# EUROPÄISCHE PATENTSCHRIFT

(11) **EP 2 132 876 B1**
(45) Veröffentlichungstag und Bekanntmachung des Hinweises auf die Patenterteilung: **15.01.2014**
(21) Anmeldenummer: 08708712.8
(22) Anmeldetag: 05.02.2008
(51) Int. Cl.: H03L 7/08, H04L 7/00, H04L 7/04

(54) **VERFAHREN, CAN-BUS-TREIBER UND CAN-BUS-SYSTEM ZUR RÜCKGEWINNUNG EINER TAKTFREQUENZ EINES CAN-BUSSES**
METHOD, CAN BUS DRIVER, AND CAN BUS SYSTEM FOR RECOVERING A CLOCK FREQUENCY OF A CAN BUS
PROCÉDÉ, CIRCUIT DE COMMANDE DE BUS CAN ET SYSTÈME BUS CAN POUR LA RÉCUPÉRATION D'UNE FRÉQUENCE D'HORLOGE D'UN BUS CAN

(30) Priorität: 09.03.2007 DE 102007011684
(43) Veröffentlichungstag der Anmeldung: 16.12.2009
(73) Patentinhaber: Robert Bosch GmbH, 70442 Stuttgart (DE)
(72) Erfinder: NEWALD, Josef, 70469 Stuttgart (DE)
(86) Internationale Anmeldenummer: PCT/EP2008/051414
(87) Internationale Veröffentlichungsnummer: WO 2008/110414

(56) Entgegenhaltungen:
- EP-A- 0 986 202
- DE-A1- 10 333 932
- DE-B3-102004 062 210
- GB-A- 2 360 152

## Beschreibung

### STAND DER TECHNIK

Die Erfindung betrifft ein Verfahren, einen CAN-Bus-Treiber und ein CAN-Bus-System zur Rückgewinnung einer Taktfrequenz eines CAN-Busses mit einer Master-Vorrichtung mit einem Taktgeber und zumindest einer Slave-Vorrichtung.

Die mittels des CAN-Busses gekoppelten Slave-Vorrichtungen, wie beispielsweise intelligente Sensoren oder Steller, sind nachteiligerweise mit hohen Kosten der Auswerteelektronik belastet. Daran hat der für den CAN-Betrieb erforderliche Schwingquarz oder Quarz einen wesentlichen Anteil. Kostengünstigere Keramikresonatoren erfüllen die Genauigkeitsanforderungen für den CAN-Bus bzw. die CAN-Schnittstelle nur ungenügend bzw. sollen aus Kostengründen ebenfalls entfallen.

Die Patentanmeldung GB 2 360 152 A offenbart ein Verfahren zur Synchronisierung des Taktgebers einer Empfangseinrichtung zum Takt eines Nachrichtensignales, bei welcher aus einem Frequenzvergleich ein Fehlersignal abgeleitet wird, welches zur Durchführung einer Korrektur des Taktes des Taktgebers herangezogen wird.

### VORTEILE DER ERFINDUNG

Das erfindungsgemäße Verfahren zur Rückgewinnung einer Taktfrequenz eines CAN-Busses mit den Merkmalen des Anspruchs 1, der CAN-Bus-Treiber mit den Merkmalen des Anspruchs 8 und das CAN-Bus-System mit den Merkmalen des Anspruchs 12 weisen jeweils den Vorteil auf, die Taktfrequenz des CAN-Busses einer mit den CAN-Bus gekoppelten Slave-Vorrichtung kostengünstig und insbesondere auf eine einfache Weise bereitzustellen.

Weiter wird erfindungsgemäß einer mit dem CAN-Bus gekoppelten Slave-Vorrichtung die Taktfrequenz des CAN-Busses ohne den Einsatz eines Keramikresonators oder eines Schwingquarzes in der Slave-Vorrichtung bereitgestellt..

Gemäß der vorliegenden Erfindung wird ein Verfahren zur Rückgewinnung einer Taktfrequenz eines CAN-Busses mit einer Master-Vorrichtung mit einem Taktgeber und zumindest einer Slave-Vorrichtung vorgeschlagen, welches die vorliegende Schritte aufweist:
a) Bereitstellen der Taktfrequenz durch den Taktgeber;
b) Senden von zumindest einem Rahmen, welcher im Header-Teil zumindest ein vorbestimmtes Bit-Muster beinhaltet, mit der bereitgestellten Taktfrequenz durch die Master-Vorrichtung über den CAN-Bus;
c) Empfangen des gesendeten Rahmens durch die Slave-Vorrichtung;
d) Extrahieren des vorbestimmten Bit-Musters aus dem empfangenen Rahmen;
e) Ausstatten der Slave-Vorrichtung mit einer Phasenregelschleife; und
f) Betreiben der Phasenregelschleife mit dem extrahierten, vorbestimmten Bit-Muster als Referenzsignal zur Rückgewinnung der Taktfrequenz des CAN-Busses in der Slave-Vorrichtung,
wobei die Master-Vorrichtung zu vorbestimmten Sendezeitpunkten jeweils einen Rahmen über den CAN-Bus sendet, welcher einen Header-Teil mit dem vorbestimmten Bit-Muster und einen Datenteil aufweist, falls der Master-Vorrichtung zu dem jeweiligen Sendezeitpunkt ein zu sendender Datenrahmen vorliegt, und einen Dummy-Rahmen sendet, der zumindest einen Header-Teil mit dem vorbestimmten Bit-Muster aufweist, falls der Master-Vorrichtung zu dem jeweiligen Sendezeitpunkt kein zu sendender Datenrahmen vorliegt.

Des Weiteren wird ein CAN-Bus-Treiber zur Rückgewinnung einer Taktfrequenz eines CAN-Busses vorgeschlagen, welcher eine Master-Vorrichtung, welche einen Taktgeber aufweist, der die Taktfrequenz des CAN-Busses bereitstellt, mit zumindest einer Slave-Vorrichtung koppelt, wobei der CAN-Bus-Treiber aufweist:
der dazu ausgelegt ist eine Master-Vorrichtung mit zumindst einer Slave-Vorrichtung zu koppeln, wobei die Master-Vorrichtung einen Taktgeber aufweist, der die Taktfrequenz des CAN-Busses bereitstellt, mit:
   d) einer Empfangseinrichtung, welche durch die Master-Vorrichtung über den CAN-Bus gesendete Rahmen empfängt, welche_im Header-Teil jeweils zumindest ein vorbestimmtes Bit-Muster beinhalten;
   e) einer Extraktionseinrichtung, welche das vorbestimmte Bit-Muster aus dem jeweiligen empfangenen Rahmen extrahiert; und
   f) einer Phasenregelschleife, welche als Referenzsignal das extrahierte, vorbestimmte Bit-Muster zur Rückgewinnung der Taktfrequenz des CAN-Busses in der Slave-Vorrichtung verwendet dadurch gekennzeichnet, dass die Empfangseinrichtung dazu ausgelegt ist, den Rahmen, der den Header-Teil mit dem vorbestimmten Bit-Muster und einen Datenteil aufweist, zu empfangen, falls der Master-Vorrichtung zu dem jeweiligen Sendezeitpunkt ein zu sendender Datemrahmen vorliegt, und einen Dummy-Rahmen zu empfangen, der zumindest einen Header-Teil mit dem vorbestimmten Bit-Muster aufweist, falls der Master-Vorrichtung zu dem jeweiligen Zeitpunkt kein zu sendender Datenrahmen vorliegt.

Weiter wird ein CAN-Bus-System vorgeschlagen, welches aufweist:
einem CAN-Bus , einer Master-Vorrichtung und zumindest einer Slave-Vorrichtung, wobei der CAN-Bus dazu ausgelegt ist, die Master-Vorrichtung mit zumindest einer Slave-Vorrichtung zu koppeln, wobei die Master-Vorrichtung einen Taktgeber aufweist, der dazu ausgelegt ist, eine Taktfrequenz für den CAN-Bus bereit zu stellen, und wobei die zumindest eine Slave-Vorrichtung zumindest einen CAN-Bus-Treiber aufweist,dadurch gekennzeichnet, dass die Master-Vorrichtung eine Sendeeinrichtung aufweist, die dazu ausgelegt ist, zu vorbestimmten Sendezeitpunkten jeweils einen_Rahmen mit der Taktfrequenz über den CAN-Bus zu senden, wobei der Rahmen_einen Header-Teil mit dem vorbestimmten Bit-Muster und einen Datenteil aufweist, falls der Master-Vorrichtung zu dem jeweiligen Sendezeitpunkt ein zu sendender Datenrahmen vorliegt, und einen Dummy-Rahmen zu senden, der zumindest einen Header-Teil mit dem vorbestimmten Bit-Muster aufweist, falls der Master-Vorrichtung zu dem jeweiligen Sendezeitpunkt kein zu sendender Datenrahmen vorliegt.

Ein Vorteil der vorliegenden Erfindung besteht darin, dass durch die erfindungsgemäße Phasenregelschleife in der Slave-Vorrichtung eine einfache und insbesondere auch kostengünstige Möglichkeit bereitgestellt ist, die Taktfrequenz des CAN-Busses in der Slave-Vorrichtung zurückzugewinnen. Somit wird die Anzahl der In einem CAN-Bus-System oder CAN-Verbund notwendigen Quarze oder Schwingquarze um N-1 verringert, wobei N die Anzahl der Knoten in dem CAN-Verbund darstellt. Die Master-Vorrichtung in dem CAN-Verbund kann insbesondere die Datenübertragungsrate bestimmen, wobei eine Änderung oder eine flexible Anpassung im Rahmen der Norm jederzeit möglich ist. Diese Änderung muss daher erfindungsgemäß auch nur in der Master-Vorrichtung vorgenommen werden. Auch eine automatische Verringerung der Baudrate zur Verringerung der Stromaufnahme oder im Stand-by-Betrieb ist erfindungsgemäß auf einfache Art und Weise möglich.

In den Unteransprüchen finden sich vorteilhafte Weiterbildungen und Ausgestaltungen des in Anspruch 1 angegebenen Verfahrens, des in Anspruch 8 angegebenen CAN-Bus-Treibers und des in Anspruch 12 angegebenen CAN-Bus-Systems.

Gemäß einer bevorzugten Ausgestaltung der Erfindung wird die Phasenregelschleife zumindest mit einem freilaufenden spannungsgesteuerten Oszillator, dessen Ausgangsfrequenz von seiner Eingangsspannung gesteuert wird, und mit einem Phasendetektor ausgestattet, dessen Ausgangsspannung in Abhängigkeit einer Phasendifferenz zwischen der Ausgangsfrequenz des spannungsgesteuerten Oszillators und dem extrahierten, vorbesstimmten Frequenzbereich(en) betreibbar, welcher die Taktfrequenz des CAN-Busses aufweist.

Gemäß einer weiteren bevorzugten Ausgestaltung wird die Phasenregelschleife zumindest bis zu einem eingeregelten Zustand betrieben, bei dem die Ausgangsfrequenz des spannungsgesteuerten Oszillators der Taktfrequenz des CAN-Busses zumindest im Wesentlichen entspricht oder entspricht.

Gemäß einer weiteren bevorzugten Ausgestaltung sendet die Master-Vorrichtung zumindest zu vorbestimmten Sendezeitpunkten jeweils einen Rahmen über den CAN-Bus.

Gemäß einer bevorzugten Weiterbildung der Erfindung sendet die Master-Vorrichtung an dem jeweiligen Sendezeitpunkt einen Datenrahmen, welcher einen Header-Teil mit dem vorbestimmten Bit-Muster und einen Datenteil aufweist, falls der Master-Vorrichtung zu dem jeweiligen Sendezeitpunkt ein zu sendender Datenrahmen vorliegt. Liegt der Master-Vorrichtung zu dem jeweiligen Sendezeitpunkt kein zu sendender Datenrahmen vor, so sendet die Master-Vorrichtung einen Dummy-Rahmen. Der Dummy-Rahmen weist zumindest einen Header-Teil mit den vorbestimmten Bit-Muster auf.

Gemäß einer weiteren bevorzugten Ausgestaltung ist das vorbestimmte Bit-Muster ein Synchronisations-Pattern eines Codec.

Gemäß einer weiteren bevorzugten Ausgestaltung ist der Taktgeber als ein Oszillator mit einem Schwingquarz ausgebildet. Damit der Slave-Vorrichtung stets Bit-Muster oder Synchronisations-Muster bereitstehen, kann die Master-Vorrichtung stets eine sehr niedrig-priore Nachricht oder Botschaft über den CAN-Bus senden. Damit der Slave-Vorrichtung das Synchronisationsmuster vorher bekannt ist, kann diese beispielsweise eine ID einer Empfangsnachricht oder Empfangsbotschaft verwenden. Falls die Slave-Vorrichtung zusätzliche Synchronisationsmuster benötigt, kann diese Fehlerrahmen oder Error Frames erzwingen, damit die aktuelle Nachricht wiederholt wird. Dies wird die Slave-Vorrichtung insbesondere dann tun, wenn sie die Synchronisation verliert und dennoch keine Nachricht oder Rahmen oder Botschaft versäumen darf. Dem Fachmann ist klar, dass die Slave-Vorrichtung nur dann sendet, wenn die Phasenregelschleife gelocked ist.

### ZEICHNUNGEN

Ausführungsbeispiele der Erfindung sind in den Zeichnungen dargestellt und in der nachfolgenden Beschreibung näher erläutert. Es zeigen:
- Figur 1: ein schematisches Ablaufdiagramm eines Ausführungsbeispiels des erfindungsgemäßen Verfahrens;
- Figur 2: ein schematisches Blockschaltbild eines Ausführungsbeispiels eines CAN-Bus-Systems gemäß der vorliegenden Erfindung; und
- Figur 3: ein schematisches Blockschaltbild eines Ausführungsbeispiels der Phasenregelschleife gemäß der vorliegenden Erfindung.

### BESCHREIBUNG DER AUSFÜHRUNGSBEISPIELE

In den Figuren bezeichnen gleiche Bezugszeichen gleiche oder funktionsgleiche Bestandteile.

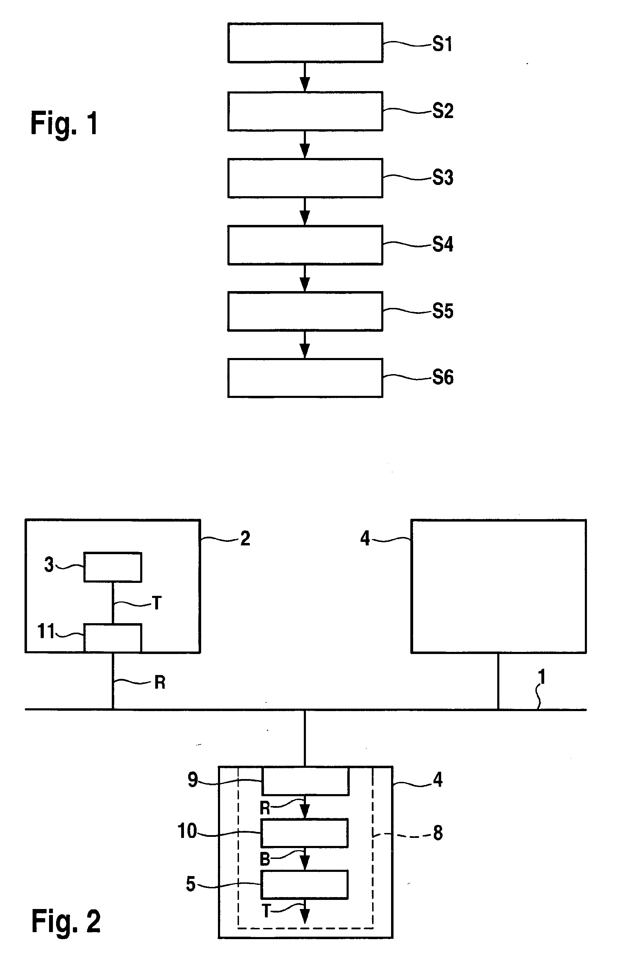

In Figur 1 ist ein schematisches Ablaufdiagramm eines Ausführungsbeispiels des erfindungsgemäßen Verfahrens zur Rückgewinnung einer Taktfrequenz T eines CAN-Busses 1 mit einer Master-Vorrichtung 2, welche einen Taktgeber 3 aufweist, und zumindest einer Slave-Vorrichtung 4 dargestellt.

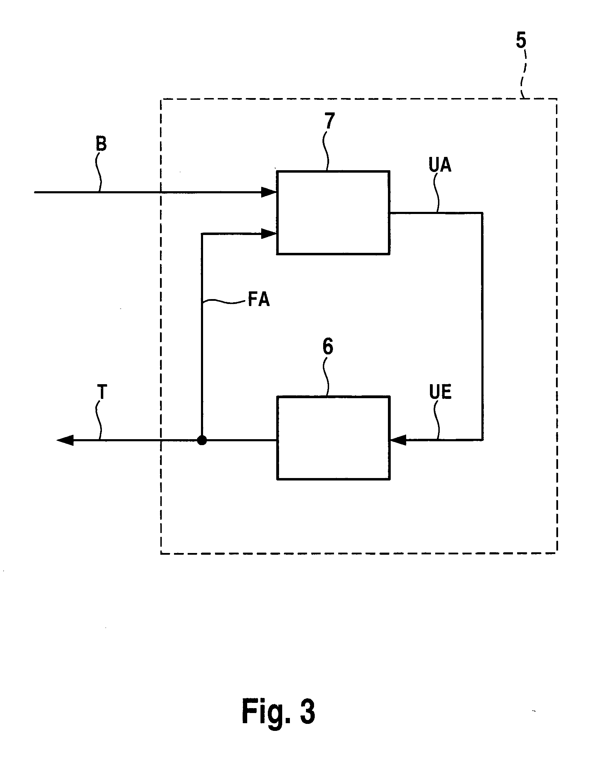

Nachfolgend wird das erfindungsgemäße Verfahren anhand des Blockschaltbildes in Figur 1 unter Verweis auf die schematischen Blockschaltbilder der Figuren 2 und 3 beschrieben. Das Ausführungsbeispiel des erfindungsgemäßen Verfahrens gemäß Figur 1 weist folgende Verfahrensschritte S1 bis S6 auf:

### Verfahrensschritt S1:

Es wird die Taktfrequenz T des CAN-Busses 1 durch den Taktgeber 3 der Master-Vorrichtung 2 bereitgestellt. Der Taktgeber 3 ist insbesondere als ein Oszillator mit einem Schwingquarz ausgebildet.

### Verfahrensschritt S2:

Zumindest ein Rahmen R, insbesondere eine vorbestimmte Anzahl von Rahmen R, wird/werden mit der bereitgestellten Taktfrequenz T durch die Master-Vorrichtung 2 über den CAN-Bus 1 gesendet. Ein Rahmen R beinhaltet zumindest ein vorbestimmtes Bit-Muster B. Insbesondere sendet die Master-Vorrichtung 2 zumindest zu vorbestimmten Sendezeitpunkten jeweils einen Rahmen R über den CAN-Bus 1.

Dabei sendet die Master-Vorrichtung 2 an dem jeweiligen Sendezeitpunkt einen Datenrahmen, welcher einen Header-Teil mit den vorbestimmten Bit-Muster B und einen Datenteil aufweist, falls der Master-Vorrichtung 2 zu dem jeweiligen Sendezeitpunkt ein zu sendender Datenrahmen vorliegt. Falls der Master-Vorrichtung 2 zu dem jeweiligen Sendezeitpunkt aber kein zu sendender Datenrahmen vorliegt, so sendet die Master-Vorrichtung 2 einen Dummy-Rahmen. Der Dummy-Rahmen weist zumindest einen Header-Teil mit dem vorbestimmten Bit-Muster B auf. Das vorbestimmte Bit-Muster B ist insbesondere ein Sychronisations-Pattern eines Codec.

### Verfahrensschritt S3:

Der jeweilige gesendete Rahmen R wird durch die Slave-Vorrichtung 4 empfangen. Dazu weist die Slave-Vorrichtung 4 insbesondere eine Empfangseinrichtung 9 auf.

### Verfahrensschritt S4:

Das vorbestimmte Bit-Muster B wird aus dem empfangenen Rahmen R extrahiert. Dazu weist die Slave-Vorrichtung 4 insbesondere eine Extraktionseinrichtung 10 auf.

### Verfahrensschritt S5:

Die Slave-Vorrichtung 4 wird mit einer Phasenregelschleife 5 (phase locked loop) ausgestattet. Die Phasenregelschleife 5 weist zumindest einen freilaufenden spannungsgesteuerten Oszillator 6 und einen Phasendetektor 7 auf. Der spannungsgesteuerte Oszillator 6 (voltage controlled oscillator; VCO) ist derart ausgestaltet, dass dessen Ausgangsfrequenz FA von seiner Eingangsspannung U E gesteuert wird (siehe Figur 3). Die Ausgangsspannung UA des Phasendetektors 7 wird in Abhängigkeit einer Phasendifferenz zwischen der Ausgangsfrequenz FA des spannungsgesteuerten Oszillators 6 und dem extrahierten, vorbestimmten Bit-Muster B bereitgestellt. Die Eingangsspannung U E des spannungsgesteuerten Oszillators 6 ist zumindest von der Ausgangsspannung UA des Phasendetektors 7 abhängig oder entspricht dieser. Weiter ist der spannungsgesteuerte Oszillator 6 in einem Frequenzbereich betreibbar, welcher die Taktfrequenz T des CAN-Busses 1 aufweist.

### Verfahrensschritt S6:

Die Phasenregelschleife 5 wird mit dem extrahierten, vorbestimmten Bit-Muster B als Referenzsignal zur Rückgewinnung der Taktfrequenz T des CAN-Busses 1 in der Slave-Vorrichtung 4 betrieben.

Dabei zeigt Figur 2 ein Ausführungsbeispiel eines CAN-Systems mit einem CAN-Bus 1, einer Master-Vorrichtung 2 und zwei Slave-Vorrichtungen 4. Die Anzahl der Slave-Vorrichtungen 4 in dem CAN-Bus-System ist allgemein N-1. Ohne Einschränkung der Allgemeinheit sind zur vereinfachten Darstellung in Figur 2 nur zwei Slave-Vorrichtungen 4 dargestellt.

Der CAN-Bus 1 koppelt die Master-Vorrichtung 2 mit den Slave-Vorrichtungen 4. Die Master-Vorrichtung 2 weist insbesondere einen Taktgeber 3 und eine Sendevorrichtung 11 auf. Der Taktgeber 3 stellt eine Taktfrequenz T für den CAN-Bus 1 bereit. Die Sendeeinrichtung 11 sendet Rahmen R mit der Taktfrequenz T über den CAN-Bus 1. Die Rahmen R weisen jeweils zumindest ein vorbestimmtes Bit-Muster B auf. Insbesondere sendet die Sendeeinrichtung 11 zumindest zu vorbestimmten Sendezeitpunkten jeweils einen Rahmen R über den CAN-Bus 1. Die Sendezeitpunkte sind insbesondere derart jeweils voneinander beabstandet, dass die Pausen zwischen den Rahmen R oder CAN-Botschaften für die Rückgewinnung der Taktfrequenz T nicht zu lang wird. Die CAN-Aktivität auf den CAN-Bus 1 wird insbesondere durch den mit dem Taktgeber 3 ausgestatteten CAN-Master 2 oder Master-Vorrichtung 2 dominiert.

Die Sendeeinrichtung 11 sendet insbesondere an dem jeweiligen Sendezeitpunkt einen Datenrahmen, welcher einen Header-Teil mit den vorbestimmten Bit-Muster B und einen Datenteil mit Nutzdaten aufweist, falls der Master-Vorrichtung 2 zu dem jeweiligen Sendezeitpunkt ein zu sendender Datenrahmen vorliegt. Falls der Master-Vorrichtung 2 zu dem jeweiligen Sendezeitpunkt aber kein zu sendender Datenrahmen vorliegt, sendet die Sendeeinrichtung 11 einen Dummy-Rahmen, der zumindest einen Header-Teil mit dem vorbestimmten Bit-Muster B aufweist. Vorzugsweise hat der Dummy-Rahmen zur Minimierung der Belastung des CAN-Busses 1 keinen Datenteil.

Die jeweilige Slave-Vorrichtung 4 weist zumindest einen CAN-Bus-Treiber 8 auf. Der CAN-Bus-Treiber 8 ist zur Rückgewinnung der Taktfrequenz T des CAN-Busses 1 geeignet. Der CAN-Bus-Treiber 8 weist eine Empfangseinrichtung 9, eine Extraktionseinrichtung 10 und eine Phasenregelschleife 5 auf. Die Empfangseinrichtung 9 empfängt die durch den Master-Vorrichtung 2 über den CAN-Bus 1 gesendeten Rahmen R. Die Rahmen R weisen jeweils zumindest ein vorbestimmtes Bit-Muster B auf. Die Extraktionseinrichtung 10 extrahiert das vorbestimmte Bit-Muster B aus dem jeweiligen empfangenen Rahmen R. Die Phasenregelschleife 5 verwendet als Referenzsignal das extrahierte, vorbestimmte Bit-Muster B zur Rückgewinnung der Taktfrequenz T des CAN-Busses 1 in der Slave-Vorrichtung 4. Das Bit-Muster B kann aus der Empfangsbotschaft kommen, falls die Mastervorrichtung spezielle Synchronisationsrahmen für die Slave-Vorrichtung unterstützt.

In Figur 3 ist ein Ausführungsbeispiel der Phasenregelschleife 5 dargestellt. Die Phasenregelschleife 5 weist zumindest einen freilaufenden spannungsgesteuerten Oszillator 6 und einen Phasendetektor 7 auf. Der spannungsgesteuerte Oszillator 6 ist derart ausgelegt, dass dessen Ausgangsfrequenz FA von seiner Eingangsspannung UE gesteuert wird. Die Ausgangsspannung UA des Phasendetektors 7 wird in Abhängigkeit einer Phasendifferenz zwischen der Ausgangsfrequenz FA des spannungsgesteuerten Oszillators 6 und dem extrahierten, vorbestimmten Bit-Muster B bereitgestellt. Die Eingangsspannung UE des spannungsgesteuerten Oszillators 6 ist zumindest von der Ausgangsspannung UA des Phasendetektors 7 abhängig oder entspricht dieser. Der spannungsgesteuerte Oszillator 6 ist insbesondere in einem vorbestimmten Frequenzbereich betreibbar, der insbesondere in seinem Mittenbereich die Taktfrequenz T des CAN-Busses 1 aufweist.

Insbesondere wird die Phasenregelschleife 5 zumindest bis zu einem eingeregelten Zustand betrieben, bei dem die Ausgangsfrequenz FA des spannungsgesteuerten Oszillators 6 der Taktfrequenz T des CAN-Busses 1 zumindest im Wesentlichen entspricht. Das vorbestimmte Bit-Muster B ist insbesondere ein Synchronisations-Pattern eines Codec.

Obwohl die vorliegende Erfindung vorstehend anhand der bevorzugten Ausführungsbeispiele beschrieben wurde, ist sie hierauf nicht beschränkt, sondern auf vielfältige Art und Weise modifizierbar.

Es wird insbesondere nur auf gültige Frames oder Rahmen synchronisiert, welche beispielsweise mit einer Bestätigungsnachricht oder einem Acknowledgement bestätigt sind. Außerdem ist es denkbar, dass Error Frames oder Fehlerrahmen erzwungen werden, falls die Phasenregelschleife ihre Synchronisation verliert. Eine Neusynchronisation kann dann schnell erfolgen, insbesondere da das Bit-Muster aus dem vorhergehenden Rahmen bereits der Slave-Vorrichtung bekannt ist.

## Patentansprüche

1. Verfahren zur Rückgewinnung einer Taktfrequenz (T) eines CAN-Busses (1) mit einer Master-Vorrichtung (2) mit einem Taktgeber (3) und zumindest einer Slave-Vorrichtung (4), mit den Schritten:
a) Bereitstellen der Taktfrequenz (T) durch den Taktgeber (3);
b) Senden von zumindest einem Rahmen (R), welcher im Header-Teil zumindest ein vorbestimmtes Bit-Muster (B) beinhaltet, mit der bereitgestellten Taktfrequenz (T) durch die Master-Vorrichtung (2) über den CAN-Bus (1);
c) Empfangen des gesendeten Rahmens (R) durch die Slave-Vorrichtung (4);
d) Extrahieren des vorbestimmten Bit-Musters (B) aus dem empfangenen Rahmen (R);
e) Ausstatten der Slave-Vorrichtung (4) mit einer Phasenregelschleife (5); **gekennzeichnet durch** das
f) Betreiben der Phasenregelschleife (5) mit dem extrahierten, vorbestimmten Bit-Muster (B) als Referenzsignal zur Rückgewinnung der Taktfrequenz (T) des CAN-Busses (1) in der Slave-Vorrichtung (4),
wobei
die Master-Vorrichtung (2) zu vorbestimmten Sendezeitpunkten jeweils einen Rahmen (R) über den CAN-Bus (1) sendet, welcher einen Header-Teil mit dem vorbestimmten Bit-Muster (B) und einen Datenteil aufweist, falls der Master-Vorrichtung (2) zu dem jeweiligen Sendezeitpunkt ein zu sendender Datenrahmen vorliegt, und einen Dummy-Rahmen sendet, der zumindest einen Header-Teil mit dem vorbestimmten Bit-Muster (B) aufweist, falls der Master-Vorrichtung (2) zu dem jeweiligen Sendezeitpunkt kein zu sendender Datenrahmen vorliegt.

2. Verfahren nach Anspruch 1,
**dadurch gekennzeichnet,**
**dass** die Phasenregelschleife (5) zumindest mit einem freilaufenden spannungsgesteuerten Oszillator (6), dessen Ausgangsfrequenz (FA) von seiner Eingangsspannung (UE) gesteuert wird, und mit einem Phasendetektor (7) ausgestattet wird, dessen Ausgangsspannung (UA) in Abhängigkeit einer Phasendifferenz zwischen der Ausgangsfrequenz (FA) des spannungsgesteuerten Oszillators (6) und dem extrahierten, vorbestimmten Bit-Muster (B) bereitgestellt wird, wobei die Eingangsspannung (UE) des spannungsgesteuerten Oszillators (6) zumindest von der Ausgangsspannung (UA) des Phasendetektors (7) abhängig ist oder dieser entspricht und der spannungsgesteuerte Oszillator (6) in einem vorbestimmten Frequenzbereich betreibbar ist, der die Taktfrequenz (T) des CAN-Busses (1) aufweist.

3. Verfahren nach Anspruch 2,
**dadurch gekennzeichnet,**
**dass** die Phasenregelschleife (5) zumindest bis zu einem eingeregelten Zustand betrieben wird, bei dem die Ausgangsfrequenz (FA) des spannungsgesteuerten Oszillators der Taktfrequenz (T) des CAN-Busses (1) zumindest im Wesentlichen entspricht.

4. Verfahren nach Anspruch 1, 2 oder 3,
**dadurch gekennzeichnet,**
**dass** durch die Master-Vorrichtung (2) eine Verringerung der Baudrate zur Verringerung der Stromaufnahme oder im Stand-by-Betrieb durchgeführt wird.

5. Verfahren nach Anspruch 4,
**dadurch gekennzeichnet**,
durch die Master-Vorrichtung (2) eine Einstellung oder Änderung der Datenübertragungsrate des CAN-Bus-Systems im Rahmen der Norm durchgeführt wird.

6. Verfahren nach Anspruch 1 oder einem der Ansprüche 2 bis 5,
**dadurch gekennzeichnet,**
**dass** das vorbestimmte Bit-Muster (B) ein Synchronisations-Pattern ist.

7. Verfahren nach Anspruch 1 oder einem der Ansprüche 2 bis 6,
**dadurch gekennzeichnet,**
**dass** der Taktgeber (3) als ein Oszillator mit einem Schwingquarz ausgebildet ist.

8. CAN-Bus-Treiber (8) zur Rückgewinnung einer Taktfrequenz (T) eines CAN-Busses (1), der dazu ausgelegt ist eine Master-Vorrichtung (2) mit zumindst einer Slave-Vorrichtung (4) zu koppeln, wobei die Master-Vorrichtung (2) einen Taktgeber (3) aufweist, der die Taktfrequenz (T) des CAN-Busses (1) bereitstellt, und wobei die Slave-Vorrichtung zumindest einen CAN-Bus-Treibes aufweist,
mit
a) einer Empfangseinrichtung (9), welche durch die Master-Vorrichtung (2) über den CAN-Bus (1) gesendete Rahmen (R) empfängt, welche_im Header-Teil jeweils zumindest ein vorbestimmtes Bit-Muster (B) beinhalten;
b) einer Extraktionseinrichtung (10), welche das vorbestimmte Bit-Muster (B) aus dem jeweiligen empfangenen Rahmen (R) extrahiert; und
c) einer Phasenregelschleife (5), **dadurch gekennzeichnet, dass** die Phasenregelschleife als Referenzsignal das extrahierte, vorbestimmte Bit-Muster (B) zur Rückgewinnung der Taktfrequenz (T) des CAN-Busses (1) in der Slave-Vorrichtung (4) verwendet, und wobei
die Empfangseinrichtung (10) dazu ausgelegt ist, den Rahmen (R), der den Header-Teil mit dem vorbestimmten Bit-Muster (B) und einen Datenteil aufweist, zu empfangen, falls der Master-Vorrichtung (2) zu dem jeweiligen Sendezeitpunkt ein zu sendender Datemrahmen vorliegt, und einen Dummy-Rahmen zu empfangen, der zumindest einen Header-Teil mit dem vorbestimmten Bit-Muster (B) aufweist, falls der Master-Vorrichtung (2) zu dem ieweiligen Zeitpunkt kein zu sendender Datenrahmen vorliegt.

9. CAN-Bus-Treiber nach Anspruch 8,
**dadurch gekennzeichnet,**
**dass** die Phasenregelschleife (5) zumindest einen freilaufenden spannungsgesteuerten Oszillator (6), dessen Ausgangsfrequenz (FA) von seiner Eingangsspannung (UE) gesteuert wird, und einen Phasendetektor (7) aufweist, dessen Ausgangsspannung (UA) in Abhängigkeit einer Phasendifferenz zwischen der Ausgangsfrequenz (FA) des spannungsgesteuerten Oszillators (6) und dem extrahierten, vorbestimmten Bit-Muster (B) bereitstellt wird, wobei die Eingangsspannung (UE) des spannungsgesteuerten Oszillators (6) zumindest von der Ausgangsspannung (UA) des Phasendetektors (7) abhängig ist oder dieser entspricht und der spannungsgesteuerte Oszillator (6) in einem vorbestimmten Frequenzbereich betreibbar ist, der die Taktfrequenz (T) des CAN-Busses (1) aufweist.

10. CAN-Bus-Treiber nach Anspruch 8 oder 9,
**dadurch gekennzeichnet**,
die Phasenregelschleife (5) zumindest bis zu einem eingeregelten Zustand betrieben wird, bei dem die Ausgangsfrequenz (FA) des spannungsgesteuerten Oszillators (6) der Taktfrequenz (T) des CAN-Busses (1) zumindest im Wesentlichen entspricht.

11. CAN-Bus-Treiber nach Anspruch 8, 9 oder 10,
**dadurch gekennzeichnet,**
**dass** das vorbestimmte Bit-Muster (B) ein Synchronisations-Pattern ist.

12. CAN-Bus-System mit:
einem CAN-Bus (1), einer Master-Vorrichtung (2) und zumindest einer Slave-Vorrichtung (4), wobei der CAN-Bus dazu ausgelegt ist die Master-Vorrichtung_(2) mit zumindest einer Slave-Vorrichtung (4) zu koppeln, wobei die Master-Vorrichtung (2) einen Taktgeber (3) aufweist, der dazu ausgelegt ist, eine_Taktfrequenz (T) für den CAN-Bus (1) bereit zu stellen, und wobei die zumindest eine Slave-Vorrichtung (4) aufweist zumindest einen CAN-Bus-Trieber (8) mit
a) einer Empfangseinrichtung (9), welche durch die Master-Vorrichtung (2) über den CAN-Bus (1) gesendete Rahmen (R) empfängt, welche_im Header-Teil jeweils zumindest ein vorbestimmtes Bit-Muster (B) beinhalten;
b) einer Extraktionseinrichtung (10), welche das vorbestimmte Bit-Muster (B) aus dem jeweiligen empfangenen Rahmen (R) extrahiert; und
c) einer Phasenregelschleife (5),
**dadurch gekennzeichnet, dass** die Phasenregelschleife als Referenzsignal das extrahierte, vorbestimmte Bit-Muster (B) zur Rückgewinnung der Taktfrequenz (T) des CAN-Busses (1) in der Slave-Vorrichtung (4) verwendet., und dass die Master-Vorrichtung (2) eine Sendeeinrichtung (11) aufweist, die dazu aufgelegt ist, zu vorbestimmten Sendezeitpunkten jeweils einen Rahmen (R) mit der Taktfrequenz (T) über den CAN-Bus (1) zu senden, wobei der Rahmen einen Header-Teil mit dem vorbestimmten Bit-Muster (B) und einen Datenteil aufweist, falls der Master-Vorrichtung (2) zu dem jeweiligen Sendezeitpunkt ein zu sendender Datenrahmen vorliegt, und einen Dummy-Rahmen zu senden, der zumindest einen Header-Teil mit dem vorbestimmten Bit-Muster (B) aufweist, falls der Master-Vorrichtung (2) zu dem jeweiligen Sendezeitpunkt kein zu sendender Datenrahmen vorliegt.

13. CAN-Bus-System nach Anspruch 12,
**dadurch gekennzeichnet,**
**dass** die Phasenregelschleife (5) des CAN-Bus-Treibers (8) zumindest einen freilaufenden spannungsgesteuerten Oszillator (6), dessen Ausgangsfrequenz (FA) von seiner Eingangsspannung (UE) gesteuert wird, und einen Phasendetektor (7) aufweist, wobei eine Ausgangsspannung (UA) des Phasendetektors (7) in Abhängigkeit einer Phasendifferenz zwischen der Ausgangsfrequenz (FA) des spannungsgesteuerten Oszillators (6) und dem extrahierten, vorbestimmten Bit-Muster (B) bereitstellt wird, und wobei die Eingangsspannung (UE) des spannungsgesteuerten Oszillators (6) zumindest von der Ausgangsspannung (UA) des Phasendetektors (7) abhängig ist oder dieser entspricht und der spannungsgesteuerte Oszillator (6) in einem vorbestimmten Frequenzbereich betreibbar ist, der die Taktfrequenz (T) des CAN-Busses (1) aufweist.

14. CAN-Bus-System nach Anspruch 12 oder 13,
**dadurch gekennzeichnet**
**dass** die Phasenregelschleife (5) zumindest bis zu einem eingeregelten Zustand betreibar ist, bei dem die Ausgangsfrequenz (FA) des spannungsgesteuerten Oszillators (6) der Taktfrequenz (T) des CAN-Busses (1) zumindest im Wesentlichen entspricht.

15. CAN-Bus-System nach Anspruch 12,
**dadurch gekennzeichnet,**
**dass** das vorbestimmte Bit-Muster (B) ein Synchronisations-Pattern ist.

16. CAN-Bus-System nach wenistens einem der Ansprüche 12 bis 15,
**dadurch gekennzeichnet,**
**dass** der Taktgeber (3) als ein Oszillator mit einem Schwingquarz ausgebildet ist.

17. CAN-Bus-System nach wenigstens einem der Ansprüche 12 bis 16,
**dadurch gekennzeichnet,**
**dass** durch die Master-Vorrichtung (2) eine Verringerung der Baudrate zur Verringerung der Stromaufnahme oder im Stand-by-Betrieb durchgerührt wird.

18. CAN-Bus-System nach wenigstens einem der Ansprüche 12, bis 17,
**dadurch gekennzeichnet,**
**dass** durch die Master-Vorrichtung (2) eine Einstellung oder Änderung der Datenübertragungsrate des CAN-Bus-Systems im Rahmen der Norm durchgeführt wird.

## Claims

1. Method for recovering a clock frequency (T) of a CAN bus (1) comprising a master device (2) having a clock generator (3) and at least one slave device (4), comprising the steps:
a) providing the clock frequency (T) by the clock generator (3);
b) transmitting at least one frame (R), which contains in the header part at least one predetermined bit pattern (B), with the provided clock frequency (T) by the master device (2) via the CAN bus (1);
c) receiving the transmitted frame (R) by the slave device (4);
d) extracting the predetermined bit pattern (B) from the received frame (R);
e) equipping the slave device (4) with a phase control loop (5); **characterized**
f) **by** operating the phase control loop (5) with the extracted, predetermined bit pattern (B) as reference signal for recovering the clock frequency (T) of the CAN bus (1) in the slave device (4),
wherein
the master device (2) transmits at predetermined transmitting times in each case one frame (R) via the CAN bus (1), which has a header part with the predetermined bit pattern (B) and a data part, if a data frame to be transmitted is available to the master device (2) at the respective transmitting time, and transmits a dummy frame, which has at least one header part with the predetermined bit pattern (B), if no data frame to be transmitted is available to the master device (2) at the respective transmitting time.

2. Method according to Claim 1,
**characterized in that**
the phase control loop (5) is equipped at least with a free-running voltage-controlled oscillator (6), the output frequency (FA) of which is controlled by its input voltage (UA), and is equipped with a phase detector (7), the output voltage (UA) of which is provided as a function of a phase difference between the output frequency (FA) of the voltage-controlled oscillator (6) and the extracted, predetermined bit pattern (B), wherein the input voltage (UE) of the voltage-controlled oscillator (6) is dependent at least on the output voltage (UA) of the phase detector (7) or corresponds to it and the voltage-controlled oscillator (6) can be operated in a predetermined frequency range which has the clock frequency (T) of the CAN bus (1).

3. Method according to Claim 2,
**characterized in that**
the phase control loop (5) is operated at least up to a steady-state condition, in which the output frequency (FA) of the voltage-controlled oscillator at least essentially corresponds to the clock frequency (T) of the CAN bus (1).

4. Method according to Claim 1, 2 or 3,
**characterized in that**
a reduction in the baud rate is performed by the master device (2) for reducing the current consumption or in the stand-by mode.

5. Method according to Claim 4,
**characterized in that**
an adjustment or a change in the data transmission rate of the CAN bus system is performed by the master device (2) in the context of the standard.

6. Method according to Claim 1 or one of Claims 2 to 5,
**characterized in that**
the predetermined bit pattern (B) is a synchronization pattern.

7. Method according to Claim 1 or one of Claims 2 to 6,
**characterized in that**
the clock generator (3) is constructed as an oscillator having an oscillating crystal.

8. CAN bus driver (8) for recovering a clock frequency (T) of a CAN bus (1) which is designed for coupling a master device (2) to at least one slave device (4), wherein the master device (2) has a clock generator (3) which provides the clock frequency (T) of the CAN bus (1), and wherein the slave device has at least one CAN bus driver, having
a) a receiving device (9) which receives frames (R) transmitted by the master device (2) via the CAN bus (1), which in each case contain at least one predetermined bit pattern (B) in the header part;
b) an extraction device (10) which extracts the predetermined bit pattern (B) from the respective received frame (R); and
c) a phase control loop (5), **characterized in that** the phase control loop uses the extracted, predetermined bit pattern (B) as reference signal for recovering the clock frequency (T) of the CAN bus (1) in the slave device (4), and wherein the receiving device (9) is designed for receiving the frame (R), which has the header part with the predetermined bit pattern (B) and a data part, if a data frame to be transmitted is available to the master device (2) at the respective transmitting time, and receiving a dummy frame, which has at least one header part with the predetermined bit pattern (B), if no data frame to be transmitted is available to the master device (2) at the respective time.

9. CAN bus driver according to Claim 8,
**characterized in that**
the phase control loop (5) has at least one free-running voltage-controlled oscillator (6), the output frequency (FA) of which is controlled by its input voltage (UE), and has a phase detector (7), the output voltage (UA) of which is provided as a function of a phase difference between the output frequency (FA) of the voltage-controlled oscillator (6) and the extracted, predetermined bit pattern (B), wherein the input voltage (UE) of the voltage-controlled oscillator (6) is dependent at least on the output voltage (UA) of the phase detector (7) or corresponds to it and the voltage-controlled oscillator (6) can be operated in a predetermined frequency range which has the clock frequency (T) of the CAN bus (1).

10. CAN bus driver according to Claim 8 or 9
**characterized in that**
the phase control loop (5) is operated at least up to a steady-state condition, in which the output frequency (FA) of the voltage-controlled oscillator (6) at least essentially corresponds to the clock frequency (T) of the CAN bus (1).

11. CAN bus driver according to Claim 8, 9 or 10,
**characterized in that**
the predetermined bit pattern (B) is a synchronization pattern.

12. CAN bus system comprising:
a CAN bus (1), a master device (2) and at least one slave device (4), wherein the CAN bus is designed for coupling the master device (2) to at least one slave device (4), wherein the master device (2) has a clock generator (3) which is designed for providing a clock frequency (T) for the CAN bus (1), and wherein the at least one slave device (4) has at least one CAN bus driver (8) having
a) a receiving device (9) which receives frames (R) transmitted by the master device (2) via the CAN bus (1), which in each case contain at least one predetermined bit pattern (B) in the header part;
b) an extraction device (10) which extracts the predetermined bit pattern (B) from the respective received frame (R); and
c) a phase control loop (5), **characterized in that** the phase control loop uses the extracted predetermined bit pattern (B) as reference signal for recovering the clock frequency (T) of the CAN bus (1) in the slave device (4), and **in that** the master device (2) has a transmitting device (11) which is designed for transmitting in each case one frame (R) with the clock frequency (T) via the CAN bus (1) at predetermined transmitting times, wherein the frame has a header part with the predetermined bit pattern (B) and a data part, if a data frame to be transmitted is available to the master device (2) at the respective transmitting time, and for transmitting a dummy frame, which has at least one header part with the predetermined bit pattern (B), if no data frame to be transmitted is available to the master device (2) at the respective transmitting time.

13. CAN bus system according to Claim 12,
**characterized in that**
the phase control loop (5) of the CAN bus driver (8) has at least one free-running voltage-controlled oscillator (6), the output frequency (FA) of which is controlled by its input voltage (UE), and has a phase detector (7), wherein an output voltage (UA) of the phase detector (7) is provided as a function of a phase difference between the output frequency (FA) of the voltage-controlled oscillator (6) and the extracted, predetermined bit pattern (B), and wherein the input voltage (UE) of the voltage-controlled oscillator (6) is dependent at least on the output voltage (UA) of the phase detector (7) or corresponds to it and the voltage-controlled oscillator (6) can be operated in a predetermined frequency range which has the clock frequency (T) of the CAN bus (1).

14. CAN bus system according to Claim 12 or 13,
**characterized in that**
the phase control loop (5) can be operated at least up to a steady-state condition, in which the output frequency (FA) of the voltage-controlled oscillator (6) at least essentially corresponds to the clock frequency (T) of the CAN bus (1).

15. CAN bus system according to Claim 12,
**characterized in that**
the predetermined bit pattern (B) is a synchronization pattern.

16. CAN bus system according to at least one of Claims 12 to 15,
**characterized in that**
the clock generator (3) is designed as an oscillator having an oscillating crystal.

17. CAN bus system according to at least one of Claims 12 to 16,
**characterized in that**
a reduction in the baud rate is performed by the master device (2) for reducing the current consumption or in the stand-by mode.

18. CAN bus system according to at least one Claims 12 to 17,
**characterized in that**
an adjustment or change in the data transmission rate of the CAN bus system is performed by the master device (2) in the context of the standard.

## Revendications

1. Procédé de récupération de la fréquence d'horloge (T) d'un bus CAN (1) présentant un dispositif-maître (2) doté d'une horloge (3) et au moins un dispositif asservi (4), le procédé présentant les étapes suivantes :
a) fourniture de la fréquence d'horloge (T) par l'horloge (3),
b) envoi par le dispositif-maître (2), sur le bus CAN (1) et à la fréquence d'horloge (T), d'au moins une trame (R) dont la partie d'en-tête contient au moins un motif prédéterminé de bit (B),
c) réception par le dispositif asservi (4) de la trame (R) envoyée,
d) extraction du motif prédéterminé de bit (B) hors de la trame (R) reçue,
e) équipement du dispositif asservi (4) d'une boucle (5) de régulation de phase,
**caractérisé par** l'étape qui consiste à
f) conduire la boucle (5) de régulation de phase à l'aide du motif prédéterminé de bit (B) qui a été extrait, comme signal de référence pour la récupération de la fréquence d'horloge (T) du bus CAN (1) dans le dispositif asservi (4),
le dispositif-maître (2) envoyant en des instants d'émission prédéterminés et sur le bus CAN (1) une trame (R) qui présente une partie d'en-tête dotée du motif prédéterminé de bit (B) et une partie de données au cas où une trame de données à envoyer est présente dans le dispositif-maître (2) à l'instant d'émission concerné et envoyant une fausse trame qui présente au moins une partie d'en-tête dotée du motif prédéterminé de bit (B) au cas où aucune trame de données à émettre n'est présente dans le dispositif-maître (2) à l'instant d'émission concerné.

2. Procédé selon la revendication 1, **caractérisé en ce que** la boucle (5) de régulation de phase est commandée au moins à l'aide d'un oscillateur (6) asservi à une tension et marchant à vide, dont la fréquence de sortie (FA) est commandée par la tension d'entrée (UE), la boucle de régulation de phase étant dotée d'un détecteur de phase (7) dont la tension de sortie (UA) est délivrée en fonction de la différence de phase entre la fréquence de sortie (FA) de l'oscillateur (6) asservi à une tension et le motif prédéterminé de bit (B) qui a été extrait, la tension d'entrée (UE) de l'oscillateur (6) asservi à une tension dépendant au moins de la tension de sortie (UA) du détecteur de phase (7) ou correspondant à cette dernière, l'oscillateur (6) asservi à une tension pouvant être conduit dans une plage de fréquences prédéterminée qui présente la fréquence d'horloge (T) du bus CAN (1).

3. Procédé selon la revendication 2, **caractérisé en ce que** la boucle (5) de régulation de phase est conduite au moins jusqu'à un état régulé dans lequel la fréquence de sortie (FA) de l'oscillateur asservi à une tension correspond au moins essentiellement à la fréquence d'horloge (T) du bus CAN (1).

4. Procédé selon les revendications 1, 2 ou 3, **caractérisé en ce qu'**une diminution du taux de bauds est exécutée par le dispositif-maître (2) pour diminuer la consommation en courant ou en mode d'attente.

5. Procédé selon la revendication 4, **caractérisé en ce qu'**un réglage ou une modification du taux de transfert de données du système de bus CAN sont exécutés par le dispositif-maître (2) dans le cadre de la norme.

6. Procédé selon la revendication 1 ou l'une des revendications 2 à 5, **caractérisé en ce que** le motif prédéterminé de bit (B) est un motif de synchronisation.

7. Procédé selon la revendication 1 ou l'une des revendications 2 à 6, **caractérisé en ce que** l'horloge (3) est configurée comme oscillateur doté d'un quartz oscillant.

8. Pilote (8) de bus CAN servant à récupérer une fréquence d'horloge (T) d'un bus CAN (1) configuré pour accoupler un dispositif-maître (2) à au moins un dispositif asservi (4), le dispositif-maître (2) présentant une horloge (3) qui délivre la fréquence d'horloge (T) du bus CAN (1), le dispositif asservi présentant au moins un pilote de bus CAN,
le pilote présentant
a) un dispositif de réception (9) qui reçoit des trames (R) émises par le dispositif-maître (2) sur le bus CAN (1) et dont la partie d'en-tête présente au moins un motif prédéterminé de bit (B),
b) un dispositif d'extraction (10) qui extrait le motif de bit (B) prédéterminé de la trame (R) qui a été reçue et
c) une boucle (5) de régulation de phase, **caractérisé en ce que**
pour récupérer la fréquence d'horloge (T) du bus CAN (1) dans le dispositif asservi (4), la boucle de régulation de phase utilise comme signal de référence le motif prédéterminé de bit (B) qui a été extrait,
**en ce que** le dispositif de réception (10) est conçu pour recevoir la trame (R) qui présente la partie d'en-tête dotée du motif prédéterminé de bit (B) et une partie de données au cas où une trame de données à envoyer est présente dans le dispositif-maître (2) à l'instant d'émission concerné et envoyant une fausse trame qui présente au moins une partie d'en-tête dotée du motif prédéterminé de bit (B) au cas où aucune trame de données à émettre n'est présente dans le dispositif-maître (2) à l'instant d'émission concerné.

9. Pilote de bus CAN selon la revendication 8, **caractérisé en ce que** la boucle (5) de régulation de phase est commandée au moins à l'aide d'un oscillateur (6) asservi à une tension et marchant à vide, dont la fréquence de sortie (FA) est commandée par la tension d'entrée (UE), la boucle de régulation de phase étant dotée d'un détecteur de phase (7) dont la tension de sortie (UA) est délivrée en fonction de la différence de phase entre la fréquence de sortie (FA) de l'oscillateur (6) asservi à une tension et le motif prédéterminé de bit (B) qui a été extrait, la tension d'entrée (UE) de l'oscillateur (6) asservi à une tension dépendant au moins de la tension de sortie (UA) du détecteur de phase (7) ou correspondant à cette dernière, l'oscillateur (6) asservi à une tension pouvant être conduit dans une plage de fréquences prédéterminée qui présente la fréquence d'horloge (T) du bus CAN (1).

10. Pilote de bus CAN selon les revendications 8 ou 9, **caractérisé en ce que** la boucle (5) de régulation de phase est conduite au moins jusqu'à un état régulé dans lequel la fréquence de sortie (FA) de l'oscillateur (6) asservi à une tension correspond au moins essentiellement à la fréquence d'horloge (T) du bus CAN (1).

11. Pilote de bus CAN selon les revendications 8, 9 ou 10, **caractérisé en ce que** le motif prédéterminé de bit (B) est un motif de synchronisation.

12. Système de bus CAN présentant :
un bus CAN (1), un dispositif-maître (2) et au moins un dispositif asservi (4),
le bus CAN étant conçu pour accoupler un dispositif-maître (2) à au moins un dispositif asservi (4), le dispositif-maître (2) présentant une horloge (3) qui délivre la fréquence d'horloge (T) du bus CAN (1), le dispositif asservi (4) présentant au moins un pilote de bus CAN (8),
le pilote présentant
a) un dispositif de réception (9) qui reçoit des trames (R) émises par le dispositif-maître (2) sur le bus CAN (1) et dont la partie d'en-tête présente au moins un motif prédéterminé de bit (B),
b) un dispositif d'extraction (10) qui extrait le motif de bit (B) prédéterminé de la trame (R) qui a été reçue et
c) une boucle (5) de régulation de phase, **caractérisé en ce que**
pour récupérer la fréquence d'horloge (T) du bus CAN (1) dans le dispositif asservi (4), la boucle de régulation de phase utilise comme signal de référence le motif prédéterminé de bit (B) qui a été extrait,
**en ce que** le dispositif maître (2) présente un dispositif d'émission (11) conçu pour envoyer en des instants prédéterminés une trame (R) à la fréquence d'horloge (T) sur le bus CAN (1), la trame présentant une partie d'en-tête dotée du motif prédéterminé de bit (B) et une partie de données au cas où une trame de données à envoyer est présente dans le dispositif-maître (2) à l'instant d'émission concerné et envoyant une fausse trame qui présente au moins une partie d'entête dotée du motif prédéterminé de bit (B) au cas où aucune trame de données à émettre n'est présente dans le dispositif-maître (2) à l'instant d'émission concerné.

13. Système de bus CAN selon la revendication 12, **caractérisé en ce que** la boucle (5) de régulation de phase du pilote (8) de bus CAN présente au moins un oscillateur (6) asservi à une tension, marchant à vide et dont la fréquence de sortie (FA) est commandée par sa tension d'entrée (UE) et un détecteur de phase (7), dont la tension de sortie (UA) du détecteur de phase (7) est délivrée en fonction de la différence de phase entre la fréquence de sortie (FA) de l'oscillateur (6) asservi à une tension et le motif prédéterminé de bit (B) qui a été extrait, la tension d'entrée (UE) de l'oscillateur (6) asservi à une tension dépendant au moins de la tension de sortie (UA) du détecteur de phase (7) ou correspondant à cette dernière, l'oscillateur (6) asservi à une tension pouvant être conduit dans une plage de fréquences prédéterminée qui présente la fréquence d'horloge (T) du bus CAN (1).

14. Système de bus CAN selon les revendications 12 ou 13, **caractérisé en ce que** la boucle (5) de régulation de phase est conduite au moins jusqu'à un état régulé dans lequel la fréquence de sortie (FA) de l'oscillateur (6) asservi à une tension correspond au moins essentiellement à la fréquence d'horloge (T) du bus CAN (1).

15. Système de bus CAN selon la revendication 12, **caractérisé en ce que** le motif prédéterminé de bit (B) est un motif de synchronisation.

16. Système de bus CAN selon au moins l'une des revendications 12 à 15, **caractérisé en ce que** l'horloge (3) est configurée comme oscillateur doté d'un quartz oscillant.

17. Système de bus CAN selon au moins l'une des revendications 12 à 16, **caractérisé en ce qu'**une diminution du taux de bauds est exécutée par le dispositif-maître (2) pour diminuer la consommation en courant ou en mode d'attente.

18. Système de bus CAN selon au moins l'une des revendications 12 à 17, **caractérisé en ce qu'**un réglage ou une modification du taux de transfert de données du système de bus CAN sont exécutés par le dispositif-maître (2) dans le cadre de la norme.
